(19) Europäisches Patentamt / European Patent Office / Office européen des brevets

(11) **EP 4 694 615 A1**

(12) **EUROPEAN PATENT APPLICATION**

(43) Date of publication:
**11.02.2026 Bulletin 2026/07**

(21) Application number: **24193831.5**

(22) Date of filing: **09.08.2024**

(51) International Patent Classification (IPC):
**H10D 12/01** (2025.01)  **H10D 12/00** (2025.01)
**H10D 62/17** (2025.01)  **H01L 21/265** (2006.01)
**H10D 30/01** (2025.01)

(52) Cooperative Patent Classification (CPC):
**H10D 12/038; H10D 12/418; H10D 12/481; H10D 30/0297; H10D 30/668; H10D 62/393**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd 8050 Zürich (CH)**

(72) Inventors:
• **GUPTA, Gaurav**
  **382421 Ahmedabad, Gujarat (IN)**
• **DE MICHIELIS, Luca**
  **5000 Aarau (CH)**
• **NIKBERG, Babak**
  **5614 Sarmenstorf (CH)**
• **SCHAER, Thomas**
  **9223 Schweizersholz (CH)**

(74) Representative: **Michalski Hüttermann & Partner Patentanwälte mbB**
  **Kaistraße 16A**
  **40221 Düsseldorf (DE)**

(54) **SEMICONDUCTOR DEVICE**

(57) The invention relates to a semiconductor device (20, 60) wherein a) for a semiconductor device (20) with a planar gate architecture a ratio of a peak doping concentration (52) in cm$^{-3}$ in a channel region (32) to a length (54) of the channel region (32) in cm between a first pn-junction and a second pn-junction along a charge carrier axis (38) is more than $5.8 \cdot 10^{21}$ cm$^{-4}$ and/or for a semiconductor device (60) with a trench gate architecture a ratio of a peak doping concentration (52) in cm$^{-3}$ in the channel region (32) to a length (54) of the channel region (32) in cm between the first pn-junction and the second pn-junction is more than $5 \cdot 10^{20}$ cm$^{-4}$ and/or b) a doping concentration (44) of the channel region (32) and a length (54) of the channel region (32) between the first pn-junction and the second pn-junction along a charge carrier axis (38) is such that a gate-emitter threshold voltage $V_{th}$ at 25 °C is above 6 V, and such that at 25 °C for

i) a 6.5 kV semiconductor device (20) a collector-emitter saturation voltage $V_{CE(sat)}$ is in between 2.8 V and 3.2 V, and/or

ii) a 4.5 kV semiconductor device (20) a collector-emitter saturation voltage $V_{CE(sat)}$ is in between 2.1 V and 2.5 V, and/or

iii) a 3.3 kV semiconductor device (60) a collector-emitter saturation voltage $V_{CE(sat)}$ is in between 2.0 V and 2.5 V, and/or

iv) a 1.7 kV semiconductor device (60) a collector-emitter saturation voltage $V_{CE(sat)}$ is in between 1.6 V and 2.0 V, and/or

v) a 1.2 kV semiconductor device (60) a collector-emitter saturation voltage $V_{CE(sat)}$ is in between 1.3 V and 1.7 V.

Furthermore, the invention relates to a method for manufacturing a semiconductor device (20, 60)

Fig. 4

EP 4 694 615 A1

**Description**

**Technical Field**

The invention relates to a semiconductor device.

Furthermore, the invention relates to method for manufacturing a semiconductor device.

Additionally, the invention relates to a semiconductor device produced by the above method.

Furthermore, the invention relates to a method for increasing the short circuit withstand capability of a semiconductor device without negatively affecting the on-state conduction losses of the semiconductor device

**Background Art**

Semiconductor devices are used as switches controlling the current flow through various electronic systems. Many semiconductor devices make use of a metal-oxide-semiconductor (MOS) structure. Devices that comprise a MOS structure are for example a MOS field-effect transistor (MOSFET), an insulated-gate bipolar transistor (IGBT), or a bi-mode insulated gate transistor (BIGT) being able to operate in both freewheeling diode mode and IGBT transistor mode.

The safe operating area (SOA) is defined as the voltage and current conditions over which a semiconductor device such as the above-mentioned IGBTs or MOSFETs can be expected to operate without self-damage or degradation. In case the semiconductor device is operated outside the SOA a breakdown of the device for example caused by a thermal runaway can occur.

For an IGBT a short-circuit failure can be explained by the following mechanism:

Electric charges are induced between the insulation layer and the interface when the gate electrode is biased, which creates an inverted channel region. Once the inverted channel region has been formed, current starts flowing through the collector electrode to the emitter electrode of the IGBT. The gate voltage at this point corresponds to the gate-emitter threshold voltage $V_{th}$ (also called gate-emitter cut off voltage $V_{GE(OFF)}$), i.e. the minimum gate-to-emitter voltage that is needed to create a conducting path or channel between the emitter/source and drain/collector electrodes. The IGBT controls the collector current Ic by the change of the electric charge induced between the insulation layer and the interface.

However, when a short-circuit failure occurs the high currents and voltages in the device lead to higher temperature which lowers $V_{th}$. This is because electric charge is generated more easily at high temperature. Short-circuit (SC) is thus a critical failure mode for semiconductor devices such as the above-mentioned IGBT, when large overcurrent levels are flowing in the electrical circuits. The time a semiconductor device such as an IGBT can withstand SC conditions, i.e. the short-circuit withstand time, is related to the gain and the thermal capacity of the semiconductor device. Higher gain leads to higher short-circuit current levels Isc within the IGBT. Hence, lower gain IGBTs will have lower short-circuit current levels Isc. However, the lower gain also results in higher on-state conduction losses, the on-state conduction losses being described by the collector current Ic multiplied by the collector-emitter saturation voltage $V_{CE(sat)}$. The collector-emitter saturation voltage $V_{CE(sat)}$ is the collector-emitter voltage when a rated gate-emitter voltage $V_{GE}$ is applied and the collector current Ic is at the rated collector current value Ic. $V_{CE(sat)}$ is also called collector-emitter saturation voltage.

In other words, the trade-off relationship of an IGBT describes the relation between on-state conduction losses and short circuit withstand capability and an IGBT can either be optimized for one of those. For example, when increasing short circuit withstand capability (by decreasing short-circuit current levels Isc) the on-state conduction losses increase. Overcoming this trade-off relationship will massively open-up the IGBT design space for an overall enhanced performance of IGBTs and other semiconductor devices.

**Summary of invention**

It is an object of the invention to increase the performance of semiconductor devices. It is a further object of the invention to increase the short circuit withstand capability with less negative effect on the on-state conduction losses.

The object of the invention is at least solved in part by the features of the independent claims. Modified embodiments are detailed in the dependent claims.

Thus, the object is at least solved in part by a semiconductor device comprising:

- a base region of a first conductivity type provided in a substrate,
- a source region being of a second conductivity type different to the first conductivity type provided in the substrate adjacent to the base region for forming a first pn-junction, the source region being configured to be connected to an emitter electrode,
- a drift region being of the second conductivity type provided in the substrate adjacent to the base region for forming a second pn-junction, the drift region being arranged separate from the source region, such that a channel region in between the source region and the drift region is formed in the base region, the drift region being configured to be connected to a collector electrode,

- an insulation layer arranged next to the channel region for separating the channel region from a gate electrode, and

a) wherein for a semiconductor device with a planar gate architecture a ratio of a peak doping concentration in cm$^{-3}$ in the channel region to a length of the channel region in cm between the first pn-junction and the second pn-junction along a charge carrier axis is more than $5.8 \cdot 10^{21}$ cm$^{-4}$; and/or for a semiconductor device with a trench gate architecture a ratio of a peak doping concentration in cm$^{-3}$ in the channel region to a length of the channel region in cm between the first pn-junction and the second pn-junction along a charge carrier axis is more than $5 \cdot 10^{20}$ cm$^{-4}$; and/or

b) wherein a doping concentration of the channel region and a length of the channel region between the first pn-junction and the second pn-junction along a charge carrier axis is such that a gate-emitter threshold voltage $V_{th}$ at 25 °C is above 6 V, , and such that at 25 °C for

i) a 6.5 kV semiconductor device a collector-emitter saturation voltage $V_{CE(sat)}$ is in between 2.8 V and 3.2 V, and/or

ii) a 4.5 kV semiconductor device a collector-emitter saturation voltage $V_{CE(sat)}$ is in between 2.1 V and 2.5 V, and/or

iii) a 3.3 kV semiconductor device a collector-emitter saturation voltage $V_{CE(sat)}$ is in between 2.0 V and 2.5 V, and/or

iv) a 1.7 kV semiconductor device a collector-emitter saturation voltage $V_{CE(sat)}$ is in between 1.6 V and 2.0 V, and/or

v) a 1.2 kV semiconductor device a collector-emitter saturation voltage $V_{CE(sat)}$ is in between 1.3 V and 1.7 V,

and wherein $V_{CE(sat)}$ is the collector-emitter voltage when a rated gate-emitter voltage $V_{GE}$ is applied and the collector current Ic is at the rated collector current value.

In a first alternative of the invention one aspect is thus that the semiconductor device has a channel design where the ratio of the peak doping concentration in cm$^{-3}$ to the length of the channel region in cm is for a planar gate architecture more than $5.8 \cdot 10^{21}$ cm$^{-4}$ and for a trench gate architecture more than $5 \cdot 10^{20}$ cm$^{-4}$. This channel design has the advantage that it breaks the trade-off relationship between the on-state conduction losses and short circuit withstand capability. Compared to channel designs known in prior art, the length of the channel is reduced while its peak doping concentration is increased. Preferably the channel length is reduced and the peak doping concentration is increased in such a way that the collector-emitter saturation voltage $V_{CE(sat)}$ remains unchanged, while the gate-emitter threshold voltage $V_{th}$ is increased. The higher threshold voltage $V_{th}$ thus results in lower short-circuit current levels Isc and thus increased short circuit withstand capabilities, while the shorter channel length prevents the collector-emitter saturation voltage $V_{CE(sat)}$ to increase. Thus, the on-state conduction losses do not increase. The gate-emitter threshold voltage $V_{th}$ is also called gate threshold voltage and is the minimum gate-to-emitter voltage that is needed to create a conducting path or channel between the emitter/source and drain/collector terminals. Preferably, the gate-emitter threshold voltage $V_{th}$ is the gate-emitter voltage at which 10 mA current flows between emitter and collector while the gate electrode is shorted to the collector electrode.

In a second alternative of the invention one aspect is thus that the doping concentration and the length of the channel region is such that the gate-emitter threshold voltage $V_{th}$ at 25 °C is above 6 V, and such that at 25 °C for

i) a 6.5 kV semiconductor device the collector-emitter saturation voltage $V_{CE(sat)}$ is in between 2.8 V and 3.2 V, and/or

ii) a 4.5 kV semiconductor device the collector-emitter saturation voltage $V_{CE(sat)}$ is in between 2.1 V and 2.5 V, and/or

iii) a 3.3 kV semiconductor device the collector-emitter saturation voltage $V_{CE(sat)}$ is in between 2.0 V and 2.5 V, and/or

iv) a 1.7 kV semiconductor device the collector-emitter saturation voltage $V_{CE(sat)}$ is in between 1.6 V and 2.0 V, and/or

v) a 1.2 kV semiconductor device the collector-emitter saturation voltage $V_{CE(sat)}$ is in between 1.3 V and 1.7 V.

In other words, the semiconductor device has improved on-state and short-circuit characteristics which are otherwise limited by the conventional trade-off between short-circuit current levels Isc and gate-emitter threshold voltage $V_{th}$. It is thus possible to gain about $\geq$ 200-300 mV in collector-emitter saturation voltage $V_{CE(sat)}$ without sacrificing the short circuit withstand capability for typical IGBTs.

In a third alternative of the invention, both above-described aspects are realized.

The invention is based on the relationship of the collector emitter current $I_{CE}$ in an IGBT, or the drain source current $I_{DS}$ in a MOSFET when approaching saturation conditions. It is known that the device's short-circuit current levels Isc is limited by the device's gate-emitter threshold voltage $V_{th}$ for an IGBT and gate-source threshold voltage $V_{th}$ for a MOSFET, respectively:

$$I_{DS} = \left[\frac{W \cdot \mu_n C_{OX} \cdot V_{DS}}{L}\left(V_{GS} - V_{th} - \frac{m \cdot V_{DS}}{2}\right)\right]$$

with W being the channel width, L being the channel length, $\mu_n$ being the mobility of the electrons in the channel, $C_{OX}$ being the capacitance of the parallel-plate capacitor formed by the gate electrode and the channel, $V_{DS}$ being the drain-to-source voltage, $V_{GS}$ being the gate-to-source voltage, and m being a bulk-charge factor.

The higher the threshold voltage $V_{th}$ the lower the device's short-circuit current levels Isc. However, a higher threshold voltage $V_{th}$ also increases the drain-source saturation voltage $V_{DS(SAT)}$ (i.e. the collector-emitter saturation voltage $V_{CE(sat)}$ in IGBT).

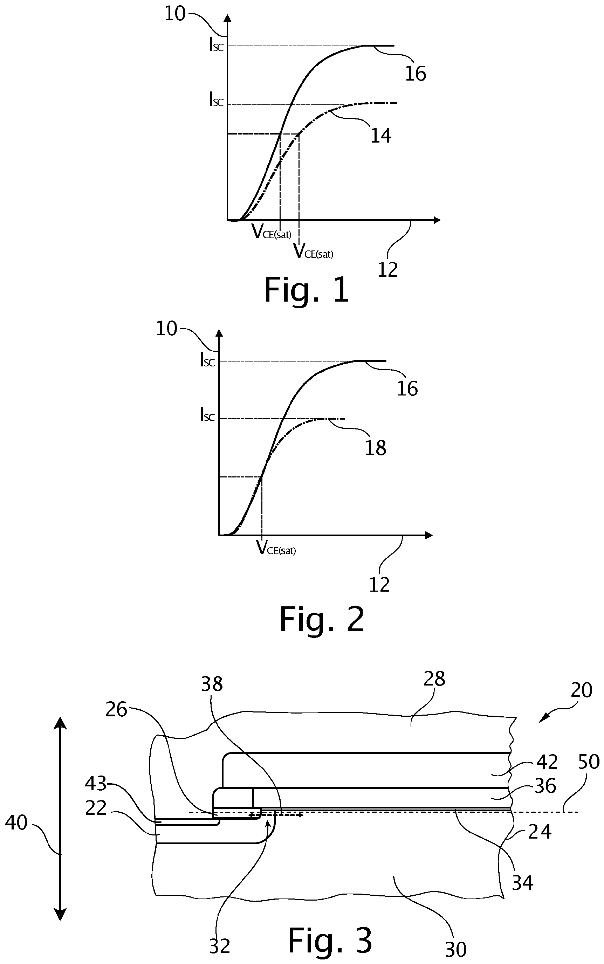

Figure 1 schematically shows the output characteristics of two IGBT devices according to prior art, and illustrates this trade-off relationship between gate-emitter threshold voltage $V_{th}$ and collector-emitter saturation voltage $V_{CE(sat)}$. On the y-axis 10 of figure 1 the collector current Ic is shown, the x-axis 12 shows the collector-emitter voltage $V_{CE}$. Figure 1 shows the output characteristics of two IGBT devices according to prior art with different gate-emitter threshold voltages Vtn. The collector current Ic illustrated by curve 14 is for the device with higher gate-emitter threshold voltage $V_{th}$, while curve 16 illustrates the collector current Ic for the device with lower gate-emitter threshold voltage Vtn. Figure 1 shows that the higher the gate-emitter threshold voltage $V_{th}$ of the device, the lower the saturation current and thus the short-circuit current levels Isc. It further shows that a higher gate-emitter threshold voltage $V_{th}$ also means that the device has a higher collector-emitter saturation voltage $V_{CE(sat)}$ and thus higher on-state conduction losses, since the on-state conduction losses are described by the collector current Ic when the collector-emitter saturation voltage $V_{CE(sat)}$ is applied multiplied by the collector-emitter saturation voltage VcE(sat).

The invention is based on the idea to accompanying the increase in gate-emitter threshold voltage $V_{th}$ with a reduction in the channel length, such that the collector-emitter saturation voltage $V_{CE(sat)}$ remains unchanged. This design idea is illustrated in figure 2. On the y-axis 10 of figure 2 the collector current Ic is shown, the x-axis 12 shows the collector-emitter voltage $V_{CE}$. The output characteristic illustrated by curve 16 is the same as in figure 1 for a device according to prior art with low gate-emitter threshold voltage Vtn. Curve 18 in figure 2 however shows that the trade-off between on-state conduction losses and short circuit withstand capability can be broken. Even though for a device with a collector current Ic according to curve 18 the gate-emitter threshold voltage $V_{th}$ is increased compared to curve 16 resulting in lower short-circuit current levels Isc and thus higher short circuit withstand capability, the lower channel length for the device with curve 18 in figure 2 compared to curve 16 in figure 2, compensates the negative effect on the collector-emitter saturation voltage $V_{CE(sat)}$. Thus, the on-state conduction losses are not increased.

Regarding the structure of the semiconductor device, the device comprises several regions provided in the substrate being adjacent to each other - i.e. the source region being provided adjacent to the base region and the drift region being provided adjacent to the base region. As the base region is of the first conductivity type, preferably p-type, and the source region and the drift region are of the second conductivity type, preferably n-type, two pn-junctions are formed within the substrate.

When a voltage $V_{GE}$ is applied to the gate electrode electric charges are induced between the insulation layer and the interface, which creates an inverted channel region, such that when the applied voltage $V_{GE}$ is above the gate-emitter threshold voltage $V_{th}$, charge carriers, preferably electrons, start flowing from the emitter electrode to the collector electrode via the channel region.

Preferably the semiconductor device can be configured with a planar gate architecture or with a trench gate architecture. In the planar gate architecture, the gate electrode is preferably arranged planarly on the semiconductor device, such that within the channel region the charge carrier axis is arranged perpendicularly to a connection axis that connects the emitter electrode with the collector electrode. In other words, the channel region is arranged horizontally, when the emitter electrode and the collector electrode are arranged vertically on top of each other.

In the trench gate architecture, the gate electrode is preferably carved into the semiconductor device, such that within the channel region the charge carrier axis is arranged parallel to a connection axis that connects the emitter electrode with the collector electrode. In other words, the channel region is arranged vertically, when the emitter electrode and the collector electrode are arranged vertically on top of each other.

According to a preferred embodiment of the invention, the semiconductor device comprises an enhancement region in the drift region, the enhancement region being arrange along the charge carrier axis adjacent to the channel region and wherein a ratio of a peak doping concentration in the channel region to a peak doping concentration in the enhancement region is more than $1.75 \cdot 10^2$. This ensures a good blocking capability of the device.

According to another preferred embodiment of the invention, the channel length is below 2 $\mu$m. Having a channel length below 2 $\mu$m provides a semiconductor device having an even more increased short circuit withstand capability without negatively affecting the on-state conduction losses.

According to a first preferred alternative embodiment of the invention a semiconductor device is provided, wherein the channel region is uniformly doped along the charge carrier axis. This is a simple way to dope the channel region and provide a channel region where the ratio of the peak doping concentration to the length of the channel is more than $5.8 \cdot 10^{21}$ cm$^{-4}$ for planar gate architecture and more than $5 \cdot 10^{20}$ cm$^{-4}$ for trench gate architecture.

According to a second preferred alternative embodiment of the invention a semiconductor device is provided, wherein the channel region is non-uniformly doped along the charge carrier axis. In other words, in this embodiment the channel region has a non-constant doping profile. This makes it possible to adapt the doping profile to the specific needs.

In connection to this and according to another preferred embodiment of the invention, the channel region comprises in a direction from the source region to the drift region along the charge carrier axis a high-low doping profile. The high-low doping profile makes the device particularly simple to manufacture.

According to another preferred embodiment of the invention, the source region is uniformly doped. Having a uniformly doped source region has the advantage that the manufacturing of the device is simplified.

According to another preferred embodiment of the invention, the features a) and b) are realized. In other words, according to this preferred embodiment a semiconductor device is provided wherein for a semiconductor device with a planar gate architecture the ratio of the peak doping concentration in cm$^{-3}$ in the channel region to the length of the channel region in cm between the first pn-junction and the second pn-junction along the charge carrier axis is more than $5.8 \cdot 10^{21}$ cm$^{-4}$ and/or for a semiconductor device with a trench gate architecture a ratio of a peak doping concentration in cm$^{-3}$ in the channel region to a length of the channel region in cm between the first pn-junction and the second pn-junction along a charge carrier axis is more than $5 \cdot 10^{20}$ cm$^{-4}$ and wherein the doping concentration of the channel region and the length of the channel region between the first pn-junction and the second pn-junction along the charge carrier axis is such that the gate-emitter threshold voltage $V_{th}$ at 25 °C is above 6 V, and such that at 25 °C for

i) a 6.5 kV semiconductor device the collector-emitter saturation voltage $V_{CE(sat)}$ is in between 2.8 V and 3.2 V, and/or
ii) a 4.5 kV semiconductor device the collector-emitter saturation voltage $V_{CE(sat)}$ is in between 2.1 V and 2.5 V, and/or
iii) a 3.3 kV semiconductor device the collector-emitter saturation voltage $V_{CE(sat)}$ is in between 2.0 V and 2.5 V, and/or
iv) a 1.7 kV semiconductor device the collector-emitter saturation voltage $V_{CE(sat)}$ is in between 1.6 V and 2.0 V, and/or
v) a 1.2 kV semiconductor device the collector-emitter saturation voltage $V_{CE(sat)}$ is in between 1.3 V and 1.7 V,

and wherein $V_{CE(sat)}$ is the collector-emitter voltage when the rated gate-emitter voltage $V_{GE}$ is applied and the collector current Ic is at the rated collector current value.

According to another preferred embodiment of the invention, a semiconductor device is provided wherein all of features i) to v) are realized. In other words, in this preferred embodiment the doping concentration of the channel region and the length of the channel region between the first pn-junction and the second pn-junction along the charge carrier axis is such that the gate-emitter threshold voltage $V_{th}$ at 25 °C is above 6 V, and such that at 25 °C for

i) a 6.5 kV semiconductor device with the collector-emitter saturation voltage $V_{CE(sat)}$ is in between 2.8 V and 3.2 V, and
ii) a 4.5 kV semiconductor device with the collector-emitter saturation voltage $V_{CE(sat)}$ is in between 2.1 V and 2.5 V, and
iii) a 3.3 kV semiconductor device with the collector-emitter saturation voltage $V_{CE(sat)}$ is in between 2.0 V and 2.5 V, and
iv) a 1.7 kV semiconductor device with the collector-emitter saturation voltage $V_{CE(sat)}$ is in between 1.6 V and 2.0 V, and
v) a 1.2 kV semiconductor device with the collector-emitter saturation voltage $V_{CE(sat)}$ is in between 1.3 V and 1.7 V.

According to another preferred embodiment of the invention, the semiconductor device comprises a planar gate architecture. According to an alternative embodiment of the invention, the semiconductor device comprises a trench gate architecture.

According to another preferred embodiment of the invention, the semiconductor device is a 6.5 kV semiconductor device preferably with a planar gate architecture. According to an alternative preferred embodiment of the invention, the semiconductor device is a 4.5 kV semiconductor device preferably with a planar gate architecture. According to further preferred alternative embodiment of the invention, the semiconductor device is a 3.3 kV semiconductor device preferably with a trench gate architecture. According to another preferred alternative embodiment of the invention, the semiconductor device is a 1.7 kV semiconductor device preferably with a trench gate architecture. And according to further preferred alternative embodiment of the invention, the semiconductor device is a 1.2 kV semiconductor device preferably with a trench gate architecture.

According to another preferred embodiment of the invention, the source region is a n-type source region, and/or the base region is a p-type base region. In other words, in this preferred embodiment the semiconductor device is preferably of the n-type channel type, where upon inversion an n-type channel is formed in the channel region, with electrons being the majority charge carriers. As electrons have a higher mobility than holes, faster switching speeds are possible.

According to another preferred embodiment of the invention, the semiconductor device is configured as MOSFET (metal-oxide-semiconductor field-effect transistor), IGBT (insulated-gate bipolar transistor), or BIGT (bi-mode insulated gate transistor). Particularly preferably the semiconductor device is configured as MOSFET or IGBT and further preferably as n-type MOSFET or n-type IGBT.

MOSFETs and IGBTs are different types of transistors having many common features, however the terminology is often different. While in an IGBT the electrode that provides the charge carriers is generally termed "emitter electrode" in a MOSFET this electrode is often termed "source electrode". On the other hand, the "collector electrode" of the IGBT is in the MOSFET often termed "drain electrode".

According to another preferred embodiment of the invention, the semiconductor device comprises a contact layer adjacent to the base region, the source region, and the emitter electrode, the contact layer being of the first conductivity type and having a higher carrier concentration than the base region. The contact region preferably provides immunity against parasitic thyristor latch-up in the semiconductor device, being potentially destructive in nature. In additional, the contact region preferably lowers the contact resistance for the emitter electrode.

According to another preferred embodiment of the invention, the semiconductor device comprises a collector layer being of the first conductivity type in between the collector electrode and the drift region. In this embodiment the semiconductor device is preferably configured as IGBT. The collector layer preferably provides together with the drift region and the base region a bipolar junction transistor arranged along the connection axis that connects the emitter electrode with the collector electrode.

According to a further preferred embodiment of the invention, the semiconductor device comprises a semiconductor material selected from the group consisting of silicon (Si), silicon carbide (SiC), gallium nitride (GaN), gallium(III) oxide ($Ga_2O_3$), aluminium nitride (AlN), aluminium gallium nitride ($Al_xGa_{1-x}N$), gallium arsenide (GaAs), and diamond. Preferably, the semiconductor material is silicon. Particularly preferably, the semiconductor device is a silicon IGBT.

Further embodiments and advantages of the semiconductor device are directly and unambiguously derived by the person skilled in the art from the description of the method for manufacturing a semiconductor device, from the description of the semiconductor device manufactured by said method and from the description of the specific examples.

The object of the invention is also solved at least in part by a method for manufacturing a semiconductor device.

Thus, according to the invention, a method for manufacturing a semiconductor device by generating a channel region in a substrate through implantation of carriers into the substrate is provided, wherein

a) implantation is performed with a ratio of a channel doping dose to a channel plateau driving time higher than $7.14 \cdot 10^{11}$ $cm^{-2}$ $min^{-1}$ and a thermal budget below $2.3 \cdot 10^5$ °C·min, wherein the thermal budget denotes the product of the channel plateau driving time and a temperature at which the carriers are diffused into the substrate; or
b) in a first step a channel precursor region in the substrate is formed through implantation of carriers of a first conductivity type into the substrate, followed by an implantation of carriers of a second conductivity type, being different to the first conductivity type to form the channel region.

In other words, a short channel region is generated either by a higher doping dose and a reduced thermal budget, or by reducing the length of the channel region with an additional step where carriers of the different conductivity type for compensating the effects of the previously implanted carriers are implanted.

According to a further preferred embodiment of the invention, the semiconductor device comprises a planar gate architecture, and the implantation of the carriers into the substrate is performed such that a ratio of a peak doping concentration in $cm^{-3}$ in the channel region to a length of the channel region is more than $5.8 \cdot 10^{21}$ $cm^{-4}$.

According to an alternative preferred embodiment of the invention, the semiconductor device comprises a trench gate architecture, and the implantation of the carriers into the substrate is performed such that the ratio of a peak doping concentration in $cm^{-3}$ in the channel region to the length of the channel region is more than $5 \cdot 10^{20}$ $cm^{-4}$.

According to another preferred embodiment of the invention, feature a) is realized and the channel doping dose is above $1.5 \cdot 10^{14}$ $cm^{-2}$. This is an easy way to ensure that a short channel with a high peak doping concentration is generated.

According to another preferred embodiment of the invention the channel region in the substrate is generated through a dual doping of dopants having different diffusion rates.

According to a further preferred embodiment of the invention, the method comprises the step of generating an enhancement region adjacent to the channel region through implantation of carriers into the substrate wherein implantation is performed such that a ratio of the peak doping concentration in the channel region to the peak doping concentration in the enhancement region is more than $1.75 \cdot 10^2$. This is preferably achieved by reducing the enhancement drive plateau time.

The invention further relates to a semiconductor device manufactured according to the above-described method.

Furthermore, the invention also relates to a method for increasing the short circuit withstand capability of a semiconductor device without negatively affecting the on-state conduction losses of the semiconductor device by generating a channel region in a substrate through implantation of carriers into the substrate, such that in comparison to a reference semiconductor device with a predefined channel length and a predefined peak doping concentration in the channel region, the channel length is reduced and the peak doping concentration is increased in such a way that a collector-emitter saturation voltage $V_{CE(sat)}$ of the semiconductor device remains unchanged.

These and other aspects of the invention will be apparent from and elucidated with reference to the embodiments described hereinafter.

In the drawings:

Fig. 1    schematically shows output characteristics of two IGBT devices according to prior art,

Fig. 2    schematically illustrates the design principle by showing output characteristics of an IGBT devices according to prior art compared to output characteristics of an IGBT according to a preferred embodiment of the invention,

Fig. 3    schematically shows a semiconductor device with a planar gate architecture according to a preferred embodiment of the invention,

Fig. 4    schematically shows a doping profile of the semiconductor device of figure 3,

Fig. 5    schematically shows a semiconductor device with a trench gate architecture according to another preferred embodiment of the invention,

Fig. 6    schematically shows a doping profile of the semiconductor device of figure 5,

Fig. 7    schematically shows simulation results for the semiconductor device of figure 5 with different channel length and varying peak doping concentration,

Fig. 8    schematically shows simulation results for the output characteristics (a) and the transfer characteristics (b) of the semiconductor device of figure 5 with two different channel length and two different peak doping concentration,

Fig. 9    schematically shows in (a) a temperature-time-profile during channel drive, and in (b) a temperature-time-profile during enhancement drive for manufacturing a semiconductor device according to a preferred embodiment of the invention and as comparison for manufacturing a reference device according to prior art,

Fig. 10   schematically shows measured output characteristics for two semiconductor devices according to preferred embodiments of the invention compared to a semiconductor device according to prior art,

Fig. 11   schematically shows measured gate-emitter threshold voltage $V_{th}$ vs. collector-emitter saturation voltage $V_{CE(sat)}$ for two semiconductor devices according to preferred embodiments of the invention compared to two semiconductor devices according to prior art, and

Fig. 12   schematically shows measured short circuit characteristics of two semiconductor devices according to preferred embodiments of the invention compared to two semiconductor devices according to prior art.

## Description of embodiments

Fig. 3 schematically shows a semiconductor device 20 with a planar gate architecture according to a preferred embodiment of the invention.

The semiconductor device 20 comprises a base region 22 of a first conductivity type provided in a substrate 24. In this embodiment the base region 22 is of p-type. The semiconductor device 20 further comprises a source region 26 being of a second conductivity type - in this embodiment n-type - provided in the substrate 24 adjacent to the base region 22 for forming a first pn-junction. The source region 26 is configured to be connected to an emitter electrode 28. The semiconductor device 20 further comprises a drift region 30 being of the second conductivity type - in this embodiment n-type - provided in the substrate 24 adjacent to the base region 22 for forming a second pn-junction. The drift region 30 is arranged separate from the source region 26, such that a channel region 32 in between the source region 26 and the drift region 30 is formed in the base region 22. Furthermore, the drift region 30 is configured to be connected to a collector electrode (not shown on figure 3). Furthermore, the semiconductor device 20 comprises an insulation layer 34 arranged next to the channel region 32 for separating the channel region 32 from a gate electrode 36.

When a voltage $V_{GE}$ is applied to the gate electrode 36 electric charges are induced, which generate the channel region 32, such that charge carriers can flow from the emitter electrode 28 to the collector electrode via the channel region 32. As in figure 3 the semiconductor device 20 is of planar gate architecture a charge carrier axis 38 along which the charges flow in the channel region 32 is arranged perpendicularly to a connection axis 40 that connects the emitter electrode 28 with the collector electrode.

As can further be seen in figure 3, in order to prevent that the gate electrode 36 is directly connected to the emitter electrode 28, a further insulation layer 42 is arranged on top of the gate electrode 36. Additionally, the semiconductor device 20 comprises a contact layer 43 adjacent to the base region 22, the source region 26, and the emitter electrode 28, the contact layer 43 being of the first conductivity type and having a higher carrier concentration than the base region 22.

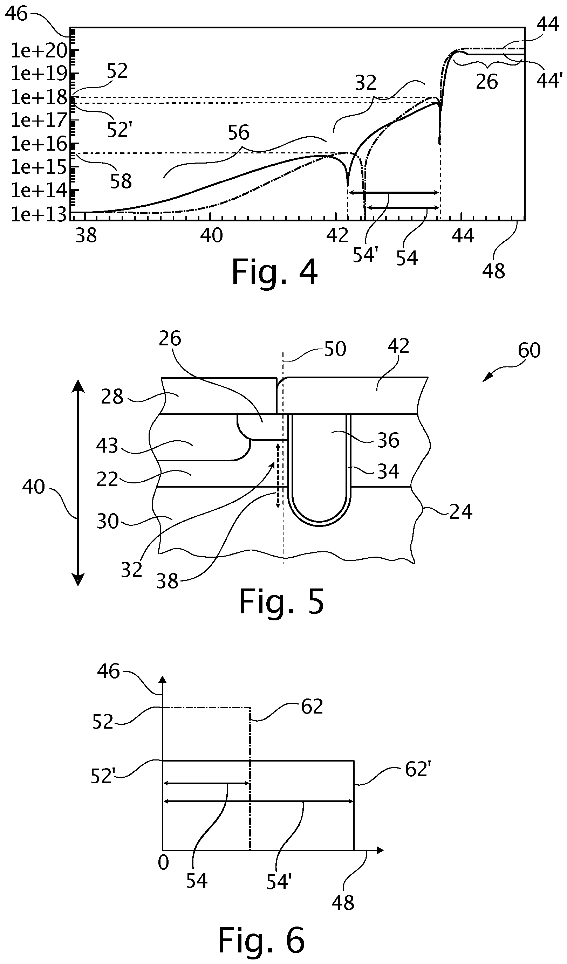

Figure 4 schematically shows a profile of a doping concentration 44 of the semiconductor device 20 of figure 3 along a direction parallel to the charge carrier axis 38. The y-axis 46 of figure 3 shows the doping concentration in $cm^{-3}$, while the x-axis 48 shows the location along the cutline 50 indicated in figure 3 parallel to the charge carrier axis 38.

As can be seen in figure 4, the doping concentration 44 for the semiconductor device 20 decreases from the source region 26 to the channel region 32. Furthermore, figure 4 shows that a ratio of a peak doping concentration 52 in $cm^{-3}$ in the channel region 32 to a length 54 of the channel region 32 in cm between the first pn-junction and the second pn-junction along the charge carrier axis 38 is more than $5.8 \cdot 10^{21}\ cm^{-4}$.

As can further be seen in figure 4, the semiconductor device 20 comprise an enhancement region 56 in the drift region 30, the enhancement region 56 being arrange along the charge carrier axis 38 adjacent to the channel region 56. For simplicity the enhancement region 56 is not shown in the schematic illustration of the semiconductor device 20 in figure 3. In this embodiment a ratio of the peak doping concentration 52 in the channel region 32 to a peak doping concentration 58 in the enhancement region 56 is more than $1.75 \cdot 10^{2}$.

For comparison, figure 4 schematically also shows a profile of a doping concentration 44' of a semiconductor device according to prior art with planar gate architecture, where a ratio of a peak doping concentration 52' in $cm^{-3}$ in the channel region 32 to a length 54' of the channel region 32 in cm between the first pn-junction and the second pn-junction along the charge carrier axis 38 is not more than $5.8 \cdot 10^{21}\ cm^{-4}$.

Figure 5 schematically shows a semiconductor device 60 with a trench gate architecture according to another preferred embodiment of the invention. Similar to the device 20 shown in figure 3, the device 60 in figure 5 comprises a base region 22 of a first conductivity type provided in a substrate 24. The semiconductor device 60 further comprises a source region 26 being of a second conductivity type provided in the substrate 24 adjacent to the base region 22 for forming a first pn-junction. The source region 26 is configured to be connected to an emitter electrode 28. The semiconductor device 60 further comprises a drift region 30 being of the second conductivity type provided in the substrate 24 adjacent to the base region 22 for forming a second pn-junction. The drift region 30 is arranged separate from the source region 26, such that a channel region 32 in between the source region 26 and the drift region 30 is formed in the base region 22. Furthermore, the drift region 30 is configured to be connected to a collector electrode (not shown on figure 5). Furthermore, the semiconductor device 60 comprises an insulation layer 34 arranged next to the channel region 32 for separating the channel region 32 from a gate electrode 36. Additionally, the semiconductor device 60 comprises a contact layer 43 adjacent to the base region 22, the source region 26, and the emitter electrode 28, the contact layer 43 being of the first conductivity type and having a higher carrier concentration than the base region 22.

When a voltage $V_{GE}$ is applied to the gate electrode 36 electric charges are induced, which generate the channel region 32, such that charge carriers can flow from the emitter electrode 28 to the collector electrode via the channel region 32. As in figure 5 the semiconductor device 60 is of trench gate architecture a charge carrier axis 38 along which the charges flow in the channel region 32 is arranged parallel to a connection axis 40 that connects the emitter electrode 28 with the collector electrode.

Figure 6 schematically shows a profile of a doping concentration 62 of the semiconductor device 60 of figure 5 along a direction parallel to the charge carrier axis 38 in the channel region 32. The y-axis 46 of figure 5 shows the doping concentration in $cm^{-3}$, while the x-axis 48 shows the location along the device 60 along the cutline 50 indicated in figure 5 parallel to the charge carrier axis 38.

As can be seen in figure 6, the doping concentration 62 for the semiconductor device 60 in the channel region 32 for this specific embodiment is uniform. Furthermore, figure 6 shows that a ratio of a peak doping concentration 52 in $cm^{-3}$ in the channel region 32 to a length 54 of the channel region 32 in cm between the first pn-junction and the second pn-junction along the charge carrier axis 38 is more than $5 \cdot 10^{20}\ cm^{-4}$. Semiconductor devices 60 with trench gate architecture can in general also have different doping profiles such as high-low doping profiles from the source region 26 to the drift region 30.

For comparison, figure 6 schematically also shows a profile of a doping concentration 62' of a semiconductor device according to prior art with trench gate architecture, where a ratio of a peak doping concentration 52' in $cm^{-3}$ in the channel region 32 to a length 54' of the channel region 32 in cm between the first pn-junction and the second pn-junction along the charge carrier axis 38 is not more than $5 \cdot 10^{20}\ cm^{-4}$.

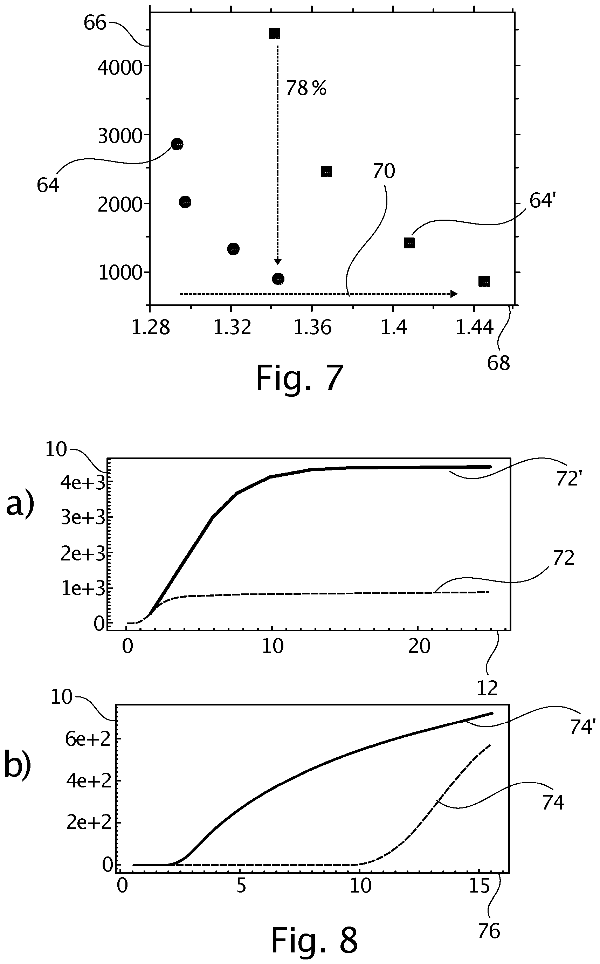

Figure 7 schematically shows simulation results 64, 64' for the semiconductor device 60 of figure 5 with different channel length 54 and varying peak doping concentration 52. The y-axis 66 of figure 7 denotes the short-circuit current levels Isc in Ampere, while the x-axis 68 denotes the collector-emitter saturation voltage $V_{CE(sat)}$ in Volt. The simulation results 64 are from a device 60 with a channel length 54 of 0.5 $\mu$m while the simulation results 64' are from a device 60 with a channel length 54 of 2 $\mu$m. Figure 7 shows that a device with a shorter channel length 54 shows an improved trade-off with about 78 % lower short-circuit current levels Isc for the same collector-emitter saturation voltage $V_{CE(sat)}$. The arrow 70 in figure 7 shows the direction of increasing gate-emitter threshold voltage $V_{th}$ for the devices.

Figure 8 schematically shows in a) simulation results for the output characteristics 72 and in b) the transfer characteristics 74 of the semiconductor device 60 of figure 5 with two different channel length 54 and two different peak doping concentration 52. Curve 72 illustrates the simulated output characteristics for a device 60 with channel length 54 of 0.5 $\mu$m and a peak doping concentration 52 of $3 \cdot 10^{17}$ cm$^{-3}$, curve 74 illustrates the simulated transfer characteristics for a device 60 with channel length 54 of 0.5 $\mu$m and a peak doping concentration 52 of $3 \cdot 10^{17}$ cm$^{-3}$. In other words, for curve 72 and curve 74, the ratio of the peak doping concentration 52 in cm$^{-3}$ in the channel region 32 to the length 54 of the channel region 32 in cm between the first pn-junction and the second pn-junction is more than $5 \cdot 10^{20}$ cm$^{-4}$. For comparison curve 72' illustrates the simulated output characteristics and curve 74' the simulated transfer characteristics for a device with channel length 54 of 2 $\mu$m and a peak doping concentration 52' of $1 \cdot 10^{16}$ cm$^{-3}$. In other words, for curve 72' and curve 74', the ratio of the peak doping concentration 52 in cm$^{-3}$ in the channel region 32 to the length 54 of the channel region 32 in cm between the first pn-junction and the second pn-junction is less than $5 \cdot 10^{20}$ cm$^{-4}$. The y-axis 10 in figures 8a) and 8b) denotes the collector current Ic. The x-axis 12 in figure 8a) denotes the collector-emitter voltage $V_{CE}$. The x-axis 76 in figure 8b) denotes the gate emitter voltage $V_{GE}$. Figure 8 shows that the device 60 with the short channel length 54 and a high peak doping concentration 52 shows higher gate-emitter threshold voltage $V_{th}$ (and thus lower short-circuit current levels Isc) without an adverse effect on the collector-emitter saturation voltage $V_{CE(sat)}$ (and thus on-state conduction losses).

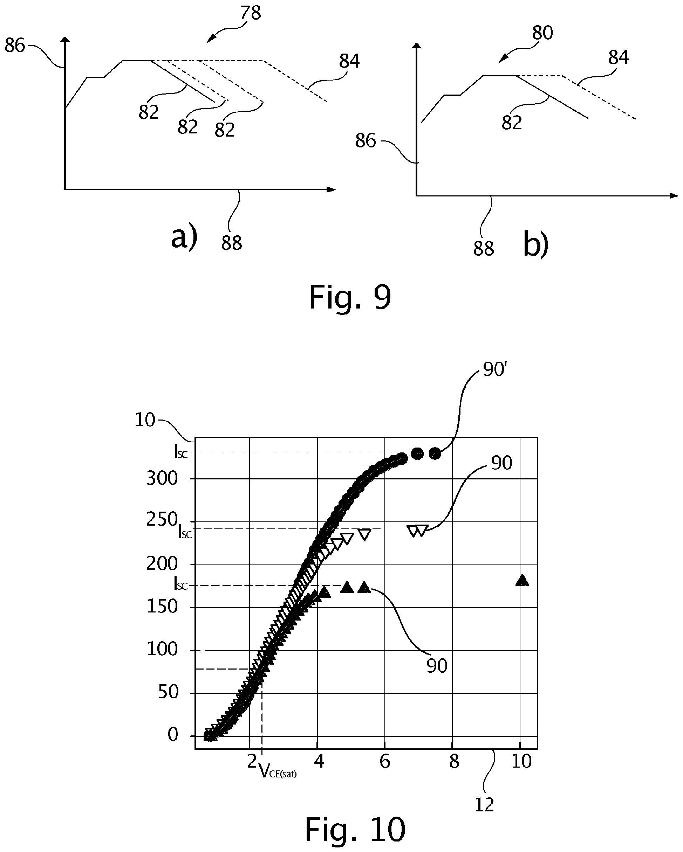

Figure 9 schematically shows in (a) a temperature-time-profile 78 during channel drive, and in (b) a temperature-time-profile 80 during enhancement drive for manufacturing a semiconductor device according to preferred embodiments of the method step 82 and as comparison a comparative method step 84 for manufacturing a reference device according to prior art. The y-axis 86 in figure 9 denotes the temperature, while the x-axis 88 denotes the time. For manufacturing the semiconductor device according to preferred embodiments of the invention, the channel doping dose is increased for raising the peak doping concentration 52 in the channel region 32. Furthermore, as can be seen in figure 9a), the channel drive plateau time is reduced for reducing the length 54 of the channel region 32. In other words, the implantation is performed with a ratio of the channel doping dose to the channel plateau driving time higher than $7.14 \cdot 10^{11}$ cm$^{-2}$ min$^{-1}$ and a thermal budget below $2.3 \cdot 10^{5}$ °C·min, wherein the thermal budget denotes the product of the channel plateau driving time and the temperature at which the carriers are diffused into the substrate.

Additionally, as can be seen in figure 9b), the enhancement drive plateau time is reduced to keep the peak doping concentration 58 in the enhancement region 56 unchanged.

Figure 10 schematically shows measured output characteristics 90 for two semiconductor devices according to preferred embodiments of the invention compared to measured output characteristics 90' for a semiconductor device according to prior art. The y-axis 10 of figure 10 denotes the collector current Ic in Ampere, while the x-axis 12 denotes the collector-emitter voltage $V_{CE}$ in Volts. The temperature for the measurement was 25 °C and the applied gate emitter voltage $V_{GE}$ was 15 V. Figure 10 shows that semiconductor devices having a channel region 32 where the ratio of the peak doping concentration 52 to the length 54 of the channel region 32 is more than $5.8 \cdot 10^{21}$ cm$^{-4}$ have systematic reductions in the short-circuit current levels Isc without compromising their on-state characteristics. Lower short-circuit current levels Isc in the semiconductor devices is related to a higher gate-emitter threshold voltage $V_{th}$. In the devices according to the preferred embodiment compared to the prior art device, the channel length 54 is reduced and the peak doping concentration 52 is increased in such a way that the collector-emitter saturation voltage $V_{CE(sat)}$ of the semiconductor device remains unchanged.

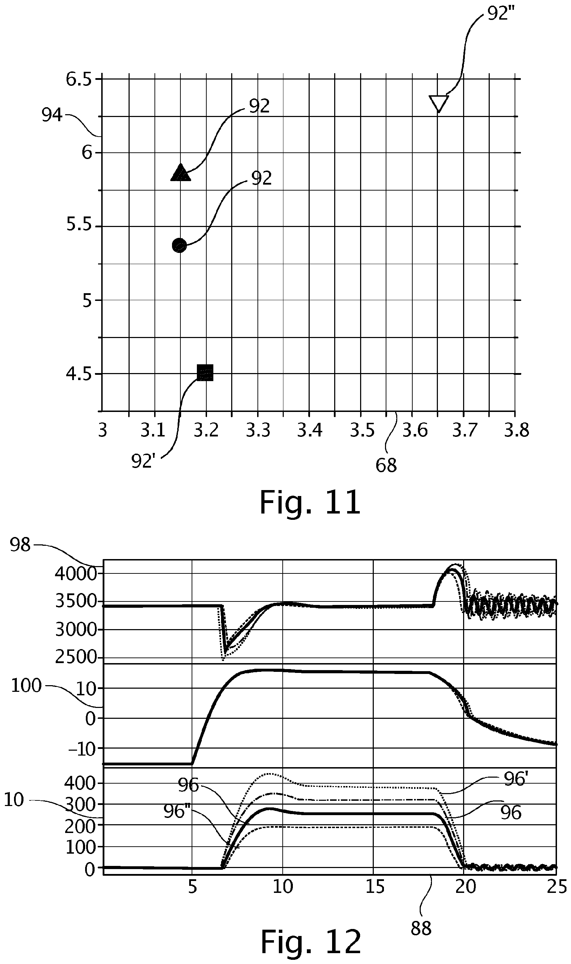

Figure 11 schematically shows measured data 92 for two semiconductor devices according to preferred embodiments of the invention compared to measured data 92', 92" for two semiconductor devices according to prior art at a temperature of 125 °C. Figure 11 plots on the y-axis 94 the gate-emitter threshold voltage $V_{th}$ in Volt and on the x-axis 68 the collector-emitter saturation voltage $V_{CE(sat)}$ in Volt. Starting from the data 92' of the semiconductor devices according to prior, the short circuit withstand capability is increased without negatively affecting the on-state conduction losses as shown by the data 92. When comparing the data 92' to the data 92" the short circuit withstand capability is also increased, however as the collector-emitter saturation voltage $V_{CE(sat)}$ is also increased the on-state conduction losses are increased.

Figure 12 schematically shows measured short circuit characteristics 96 of the two semiconductor devices according to preferred embodiments of the invention compared to measured short circuit characteristics 96', 96" of the two semiconductor devices according to prior art at a temperature of 125 °C and with a collector-emitter voltage $V_{CE}$ of 3400 V. The x-axis 88 in figure 12 represents the time in microseconds, the y-axis 98 on the top diagram denotes the collector-emitter voltage $V_{CE}$ in Volt, the y-axis 100 in the middle diagram denotes the gate emitter voltage $V_{GE}$ in Volt, and the y-axis 10 in the bottom diagram denotes the collector current Ic in Ampere. The diagram shows that the two semiconductor devices according to the preferred embodiments have compared to the short circuit characteristics 96' of the device according to prior art a lower collector current Ic during short circuit conditions. The prior art device with the short circuit characteristics 96" has an even lower collector current Ic, however for this device, as is shown in figure 11, the on-state conduction losses are increased.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosed, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

**Reference signs list**

| | |
|---|---|
| 10 | y-axis, collector current Ic |
| 12 | x-axis, collector-emitter voltage $V_{CE}$ |
| 14 | collector current Ic for prior art IGBT with high gate-emitter threshold voltage $V_{th}$ |
| 16 | collector current Ic for prior art IGBT with low gate-emitter threshold voltage $V_{th}$ |
| 18 | collector current Ic for IGBT with high gate-emitter threshold voltage $V_{th}$ and short channel length |
| 20 | semiconductor device with planar gate architecture |
| 22 | base region |
| 24 | substrate |
| 26 | source region |
| 28 | emitter electrode |
| 30 | drift region |
| 32 | channel region |
| 34 | insulation layer |
| 36 | gate electrode |
| 38 | charge carrier axis |
| 40 | connection axis |
| 42 | further insulation layer |
| 43 | contact layer |
| 44 | doping concentration profile for device 20 |
| 44' | doping concentration profile for prior art device with planar gate architecture |
| 46 | y-axis, doping concentration |
| 48 | x-axis, location |
| 50 | cutline |
| 52 | peak doping concentration in channel region |
| 54 | length of channel region |
| 56 | enhancement region |
| 58 | peak doping concentration in enhancement region |
| 60 | semiconductor device with trench gate architecture |
| 62 | doping concentration profile for device 60 |
| 62' | doping concentration profile for prior art device with trench gate architecture |
| 64 | simulation results for device with channel length of 0.5 $\mu$m |
| 64' | simulation results for device with channel length of 2 $\mu$m |
| 66 | y-axis, short-circuit current levels Isc |
| 68 | x-axis, collector-emitter saturation voltage $V_{CE(sat)}$ |
| 70 | Arrow, showing direction of increasing gate-emitter threshold voltage $V_{th}$ |
| 72 | simulated output characteristics for device 60 with channel length of 0.5 $\mu$m and peak doping concentration of $3 \cdot 10^{17}$ cm$^{-3}$ |
| 72' | simulated output characteristics for prior art device with channel length of 2 $\mu$m and peak doping concentration of $1 \cdot 10^{16}$ cm$^{-3}$ |
| 74 | simulated transfer characteristics for device 60 with channel length of 0.5 $\mu$m and peak doping concentration of $3 \cdot 10^{17}$ cm$^{-3}$ |

74'  simulated transfer characteristics for prior art device with channel length of 2 $\mu$m and peak doping concentration of $1 \cdot 10^{16}$ cm$^{-3}$

76  x-axis, gate emitter voltage $V_{GE}$

78  Temperature-time-profile during channel drive

80  Temperature-time-profile during enhancement drive

82  preferred embodiment of method step

84  comparative method step according to prior art

86  y-axis, temperature

88  x-axis, time

90  measured output characteristics

90'  measured output characteristics for prior art device

92  measured data for device

92'  measured data for prior art device

92"  measured data for prior art device

94  y-axis, gate-emitter threshold voltage $V_{th}$

96  measured short circuit characteristics

96'  measured short circuit characteristics for prior art device

96"  measured short circuit characteristics for prior art device

98  y-axis, collector-emitter voltage $V_{CE}$

100  y-axis, gate emitter voltage $V_{GE}$

**Claims**

1. Semiconductor device (20, 60) comprising:

- a base region (22) of a first conductivity type provided in a substrate (24),
- a source region (26) being of a second conductivity type different to the first conductivity type provided in the substrate (24) adjacent to the base region (22) for forming a first pn-junction, the source region (26) being configured to be connected to an emitter electrode (28),
- a drift region (30) being of the second conductivity type provided in the substrate (24) adjacent to the base region (22) for forming a second pn-junction, the drift region (30) being arranged separate from the source region (26), such that a channel region (32) in between the source region (26) and the drift region (30) is formed in the base region (22), the drift region (30) being configured to be connected to a collector electrode,
- an insulation layer (34) arranged next to the channel region (32) for separating the channel region (32) from a gate electrode (36), and
a) wherein for a semiconductor device (20) with a planar gate architecture a ratio of a peak doping concentration (52) in cm$^{-3}$ in the channel region (32) to a length (54) of the channel region (32) in cm between the first pn-junction and the second pn-junction along a charge carrier axis (38) is more than $5.8 \cdot 10^{21}$ cm$^{-4}$; and/or for a semiconductor device (60) with a trench gate architecture a ratio of a peak doping concentration (52) in cm$^{-3}$ in the channel region (32) to a length (54) of the channel region (32) in cm between the first pn-junction and the second pn-junction along a charge carrier axis (38) is more than $5 \cdot 10^{20}$ cm$^{-4}$ and/or
b) wherein a doping concentration (44) of the channel region (32) and a length (54) of the channel region (32) between the first pn-junction and the second pn-junction along a charge carrier axis (38) is such that a gate-emitter threshold voltage $V_{th}$ at 25 °C is above 6 V, and such that at 25 °C for

i) a 6.5 kV semiconductor device (20) a collector-emitter saturation voltage $V_{CE(sat)}$ is in between 2.8 V and 3.2 V, and/or

ii) a 4.5 kV semiconductor device (20) a collector-emitter saturation voltage $V_{CE(sat)}$ is in between 2.1 V and 2.5 V, and/or

iii) a 3.3 kV semiconductor device (60) a collector-emitter saturation voltage $V_{CE(sat)}$ is in between 2.0 V and 2.5 V, and/or

iv) a 1.7 kV semiconductor device (60) a collector-emitter saturation voltage $V_{CE(sat)}$ is in between 1.6 V and 2.0 V, and/or

v) a 1.2 kV semiconductor device (60) a collector-emitter saturation voltage $V_{CE(sat)}$ is in between 1.3 V and 1.7 V,

and wherein $V_{CE(sat)}$ is the collector-emitter voltage when a rated gate-emitter voltage $V_{GE}$ is applied and the collector current Ic is at the rated collector current value.

2. Semiconductor device (20, 60) according to claim 1, wherein the semiconductor device (20, 60) comprises an enhancement region (56) in the drift region (30), the enhancement region (56) being arrange along the charge carrier axis (38) adjacent to the channel region (32) and wherein a ratio of a peak doping concentration (52) in the channel region (32) to a peak doping concentration (58) in the enhancement region (56) is more than $1.75 \cdot 10^2$.

3. Semiconductor device (20, 60) according to any of the previous claims, wherein the channel length (54) is below 2 $\mu$m.

4. Semiconductor device (20, 60) according to any of the previous claims, wherein the channel region (32) is uniformly doped along the charge carrier axis (38).

5. Semiconductor device (20, 60) according to any of claims 1 to 3, wherein the channel region (32) is non-uniformly doped along the charge carrier axis (38).

6. Semiconductor device (20, 60) according to the previous claim, wherein the channel region (32) comprises in a direction from the source region (26) to the drift region (30) along the charge carrier axis (38) a high-low doping profile.

7. Semiconductor device (20, 60) according to any of the previous claims, wherein the source region (26) is uniformly doped.

8. Semiconductor device (20, 60) according to any of the previous claims, wherein features a) and b) are realized.

9. Semiconductor device (20, 60) according to any of the previous claims, wherein all of features i) to v) are realized.

10. Semiconductor device (20, 60) according to any of the previous claims, wherein the source region (26) is a n-type source region, and/or the base region (22) is a p-type base region.

11. Semiconductor device (20, 60) according to any of the previous claims, wherein the semiconductor device (20, 60) is configured as MOSFET, IGBT, or BIGT.

12. Semiconductor device (20, 60) according to any of the previous claims, wherein the semiconductor device (20, 60) comprises a contact layer (43) adjacent to the base region (22), the source region (26), and the emitter electrode (28), the contact layer (43) being of the first conductivity type and having a higher carrier concentration than the base region (22).

13. Semiconductor device (20, 60) according to any of the previous claims, wherein the semiconductor device (20, 60) comprises a collector layer being of the first conductivity type in between the collector electrode and the drift region (30).

14. Method for manufacturing a semiconductor device (20, 60) by generating a channel region (32) in a substrate (24) through implantation of carriers into the substrate (24), wherein

    a) implantation is performed with a ratio of a channel doping dose to a channel plateau driving time higher than $7.14 \cdot 10^{11}$ cm$^{-2}$ min$^{-1}$ and a thermal budget below $2.3 \cdot 10^5$ °C·min, wherein the thermal budget denotes the product of the channel plateau driving time and a temperature at which the carriers are diffused into the substrate (24); or
    b) in a first step a channel precursor region in the substrate (24) is formed through implantation of carriers of a first conductivity type into the substrate (24), followed by an implantation of carriers of a second conductivity type, being different to the first conductivity type to form the channel region (32).

15. Method according to the previous claim, wherein the semiconductor device (20) comprises a planar gate architecture, and wherein implantation of the carriers into the substrate (24) is performed such that a ratio of a peak doping concentration (52) in cm$^{-3}$ in the channel region (32) to a length (54) of the channel region (32) of more than $5.8 \cdot 10^{21}$ cm$^{-4}$; or
    wherein the semiconductor device (60) comprises a trench gate architecture, and wherein implantation of the carriers into the substrate (24) is performed such that a ratio of a peak doping concentration (52) in cm$^{-3}$ in the channel region (32) to a length (54) of the channel region (32) of more than $5 \cdot 10^{20}$ cm$^{-4}$.

16. Method according to the previous claim, wherein feature a) is realized and the channel doping dose is above $1.5 \cdot 10^{14}$

cm$^{-2}$.

17. Method according to any of the previous method claims, wherein the channel region in the substrate is generated through a dual doping of dopants having different diffusion rates.

18. Semiconductor device (20, 60) manufactured according to any of the previous method claims.

Fig. 1

Fig. 2

Fig. 3

Fig. 4

Fig. 5

Fig. 6

Fig. 7

Fig. 8

Fig. 9

Fig. 10

Fig. 11

Fig. 12

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 120 360 A1 (HITACHI ENERGY SWITZERLAND AG [CH]) 18 January 2023 (2023-01-18) | 1,2,4-13 | INV. H10D12/01 H10D12/00 |
| A | * Figure 2 and the correlated text * ----- | 3,14-18 | H10D62/17 H01L21/265 |
| X | EP 4 120 357 A1 (HITACHI ENERGY SWITZERLAND AG [CH]) 18 January 2023 (2023-01-18) | 1-13 | H10D30/01 |
| A | * Figure 1 and the correlated text * ----- | 14-18 | |
| X | EP 0 893 821 A1 (ST MICROELECTRONICS SRL [IT]) 27 January 1999 (1999-01-27) | 1,3, 7-12, 14-16,18 | |
| A | * Figures 1-4 and the correlated text * ----- | 2,5,6, 13,17 | |
| X | US 8 476 697 B1 (COOPER JAMES A [US] ET AL) 2 July 2013 (2013-07-02) | 1,3,4, 7-12, 14-18 | |
| A | * Figure 4 and the correlated text * ----- | 2,5,6,13 | |

TECHNICAL FIELDS SEARCHED (IPC)

H10D
H01L

The present search report has been drawn up for all claims

| Place of search | Date of completion of the search | Examiner |
|---|---|---|
| Munich | 8 January 2025 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 3831

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2025

| Patent document cited in search report | | Publication date | Patent family member(s) | | Publication date |
|---|---|---|---|---|---|
| EP 4120360 | A1 | 18-01-2023 | CN | 117652033 A | 05-03-2024 |
| | | | DE | 212022000251 U1 | 15-04-2024 |
| | | | EP | 4120360 A1 | 18-01-2023 |
| | | | JP | 2024525835 A | 12-07-2024 |
| | | | WO | 2023285550 A1 | 19-01-2023 |
| EP 4120357 | A1 | 18-01-2023 | CN | 117693819 A | 12-03-2024 |
| | | | DE | 212022000254 U1 | 15-04-2024 |
| | | | EP | 4120357 A1 | 18-01-2023 |
| | | | JP | 2024525829 A | 12-07-2024 |
| | | | WO | 2023285557 A1 | 19-01-2023 |
| EP 0893821 | A1 | 27-01-1999 | EP | 0893821 A1 | 27-01-1999 |
| | | | JP | H11102919 A | 13-04-1999 |
| | | | US | 6221719 B1 | 24-04-2001 |
| US 8476697 | B1 | 02-07-2013 | US | 8133789 B1 | 13-03-2012 |
| | | | US | 8476697 B1 | 02-07-2013 |

EPO FORM P0459

For more details about this annex : see Official Journal of the European Patent Office, No. 12/82